(19) Europäisches Patentamt
European Patent Office
Office européen des brevets

(11) Publication number: **0 144 148**
**A2**

# (12) EUROPEAN PATENT APPLICATION

(21) Application number: 84307405.5

(22) Date of filing: 26.10.84

(51) Int. Cl.[4]: C 08 F 2/50

(30) Priority: 28.10.83 US 546334

(43) Date of publication of application: 12.06.85 Bulletin 85/24

(84) Designated Contracting States: DE FR GB

(71) Applicant: LOCTITE (IRELAND) Ltd.
Whitestown Industrial Estate
Tallaght, Co. Dublin(IE)

(72) Inventor: Woods, John
138 Stillorgan Wood Upper Kilmacud Road
Stillorgan County Dublin(IE)

(72) Inventor: Casey, Tadgh Eisirt
Brookwood Tubber
Lucan County Dublin(IE)

(74) Representative: Marchant, James Ian et al,
Elkington and Fife High Holborn House 52/54 High Holborn
London WC1V 6SH(GB)

## (54) Photocurable compositions containing prepolymers of two curing types.

(57) A photocurable composition which cures rapidly and dry to the touch comprising:

a) (meth)acrylate functional monomer or prepolymer;

b) a cationically curable monomer or prepolymer;

c) a free-radical liberating, carbonyl containing, photoinitiator; and

d) an aromatic halonium salt whose anion is a complex metal halide.

The free radical photoinitiator accelerates polymerization of the cationic curable ingredient as well as initiating polymerization of the (meth)acrylate ingredient.

Compositions which further comprise between about 10% and 20% of carboxyl terminated nitrile rubber are especially suited for bonding polybutyleneterephthalate.

EP 0 144 148 A2

Croydon Printing Company Ltd.

## FIELD OF THE INVENTION

This invention relates to curing compositions which are photoinitiated in the sense that polymerization takes place in the compositions following their exposure to light. The light energy activates an initiator system comprising a compound or compounds which, following such activation, are effective to cause polymerization of a prepolymer or prepolymers likewise present in the composition. The result is a solid matrix of cured composition having dimensions similar to those previously imposed on the composition, as by spreading it on a substrate or enclosing it in a mould. Compositions of this type are referred to hereinafter as photocuring compositions.

## BRIEF DESCRIPTION OF THE PRIOR ART

Photocuring compositions based on acrylate and/or methacrylate prepolymers ("A-type compositions") are known. They often contain, or involve the use of, a small proportion of a carbonyl compound (or compounds) which by absorbing radiation becomes adapted to release free radicals and hence to act as a photoinitiator or photosensitizer for polymerization of the acrylate-type prepolymer(s). A-type compositions do not cure fully in the presence of air, so that coatings made from them have tacky surfaces, which is a disadvantage.

Photocuring compositions based on cationically curable prepolymers ("E-type compositions") such as prepolymers containing an epoxide group, are also known. They often contain a small proportion of an onium salt (or salts) which likewise by absorbing radiation becomes adapted to release acid and hence to act as a photoinitiator or photosensitizer for polymerization of the epoxide-type prepolymer(s). E-type compositions cure only very

slowly (compared with A-type compositions) and are difficult to cure in depth, i.e., in thick sections, or when modified by the presence of pigments and dyes. These are disadvantages of E-type compositions.

It is known to increase the rate of E-type compositions and other compositions based on cationically curable prepolymers, by incorporating sensitizers, i.e., substances which increase the wavelength spectrum sensitivity of the onium salt, in the compositions: Firas A M et al, Polymer, Vol. 19 page 1219 (1978) and Ledwith A and McGuiness R C, European Patent Application NO. 0010897.

Sensitizers which have been used (especially for E-type compositions containing an onium salt, or salts, of an element of group VIa of the periodic table) include polycylcic aromatic compounds such as perylene. To use them involves the disadvantage of additional work in manufacture; more seriously however, many of these sensitizers are suspected or proven carcinogens, and are thus unlikely to be of practical use in making commercial compositions. Such sensitizers are described in US Patent 4,069,054 to Smith G H.

One known type of group VIa onium sensitizer comprises aromatically substituted sulfonium salts, wherein the aromatic substituent is one or more monoaryl (single ring) groups. It has been proposed to replace one or more of these aryl radicals by a polyaryl ether radical or a polyaryl thioether radical. Such materials are described in US Patent 4,173,476 and in UK Patent Application 2,061,280A where it is stated that the compounds are particularly useful for curing compositions comprising cationically curable monomers in thick sections. These materials are characterized by an absorption peak at about 308 nm in the UV

wavelength spectrum. It is stated elsewhere (Crivello, J V, Developments in Polymer Photochemistry, Vol. II, Chap. 1 (1981)) by way of explanation that the incorporation of such radicals into the sensitizer molecule enhances the spectral response of the sensitizer in the long wavelength region.

Compositions containing an aromatically substituted sulfonium salt produce on photolysis a sulfide which has a bad smell, a further disadvantage.

Several attempts have been made to combine in a single composition the essential components of an A-type and an E-type composition with a view to the elimination of their respective disadvantages. Such compositions, hereinafter referred to generally as "AE-type", have been disclosed, for example, by Jung-Hsien Tsao and Ketley A D in US Patent 4,156,035. In this case the materials responsible for curing the epoxide component of the composition have been limited to group VIa onium salts. Furthermore the said salts and the carbonyl compounds function independently and do not interact mutually to produce any useful effect, or indeed any effect so far as is known. The salts act as initiators for both of the prepolymer types contained in the compositions, whereas the carbonyl compounds do so for the acrylate prepolymers only. That sensitization does not occur between sulfonium salts and carbonyl photoinitiators/photosensitizers has been shown by Pappas S P and Jilek J H Photogr. Sci. and Eng. 23, (3), 141, (1979), and this probably applies to group VIa onium salts in general.

## BACKGROUND OF THE INVENTION

The invention seeks to mitigate or remove at least some of the above-recited disadvantages of A-type, E-type and AE-type compositions of the prior art, by providing an AE-type composition wherein the respective photoinitiators cooperate to produce some of the desired effect and properties of the composition. The fact that some carbonyl compounds (used as photoinitiators) have an effect on some onium salts (also used as photoinitiators) in increasing their spectral sensitivity and the magnitude of their response to incident radiation has been documented, but only in the context of E-type compositions, i.e. for systems based only on epoxides and other cationically curable monomers. (See e.r. Firas A M et al, Polymer, Vol. 19, page 1219, (1978), and Ledwith A European Patent Application No. 0010897). The invention sets out from the above state of the art.

SUMMARY OF THE INVENTION

The invention accordingly provides an AE-type curing composition as hereinbefore defined, which comprises a) at least one monomer or prepolymer the molecule of which contains at least one acrylate or methacrylate group, b) at least one cationcally curable monomer or prepolymer, c) at least one free radical-liberating photoinitiator which comprises a carbonyl compound, and d) at least one aromatic halonium salt whose anion is a complex metal halide.

PREFERRED EMBODIMENTS

The molecule of ingredient b) preferably contains at least one epoxide group. Ingredient d) is used as a photoinitiator. The preferred proportions of the four essential ingredients in the composition by weight are as follows:
a) 1-99%; b) 1-99%; c) 0.05-10%; d) 0.1-10%. More preferable are the following proportions:

a) 40-60%; b) 37-57%; c) 0.5-2%; d) 1-3%.
Typical proportions in actual use are:
a) 50%; b) 47%; c) 1%; d) 2%.

## ADVANTAGES OF THE INVENTION

On exposure of the composition to light, particularly ultra-violet (UV) light, the free radical photoinitiator causes the (meth)acrylate component to polymerize, while the aromatic halonium salt causes both the (meth)acrylate and the epoxide components to polymerize simutaneously. The free radical photoinitiator also serves to accelerate the rate at which the aromatic halonium salt polymerizes the epoxide components, and this latter effect is an important advantage of the present invention.

The compositions of the invention are an improvement over A-type compositions based only on (meth)acrylate monomers and free radical photoinitiators, and over E-type compositions based only on epoxide monomers and aromatic halonium salts.

They also represent an improvement over those AE-type compositions which are known to the art. The disadvantages of all three types A, E, AE of prior art compositions have been described above. In addition, compositions based on acrylate or methacrylate monomers and incorporating onium salts, such as aromatic halonium salts, as photoinitiator are known. Not only are they slow to cure, however, but they give a tacky surface, thereby combining disadvantages of A and E-type compositions. In contrast, and suprisingly, the compositions of the invention can be photocured in air quickly and in thick sections, giving tack-free surfaces.

The use of aromatic halonium salts in AE-type compositions offers several advantages over the prior art compositions containing group VIa onium salts: an increase in the wavelength spectrum sensitivity of the salts towards the visible light region of the spectrum caused by a sensitizing reaction between the free radical carbonyl photoinitiator and the aromatic halonium salt. This sensitization reaction results in faster rates of polymerization for the composition, as determined for example by the gel test (see the examples herein). It also allows pigments and dyes to be used which would, in an unsensitized formulation, effectively compete with the onium salt for the available radiation thus preventing cure of the epoxide component. The said reaction additionally reduces the exposure time necessary at a given intensity of radiation, since the increase in spectrum sensitivity is towards wavelengths which predominate in the output of commercially available UV lamps. Furthermore, iodonium photolysis by-products, formed in the use of the present compositions, do not have a bad smell.

A special embodiment of the invention which employs about 10-20% of a carboxyl terminated nitrile rubber as an additional ingredient has also unexpectedly been found to give superior bonding to polybutylene terephthalate.

## DETAILED DESCRIPTION OF THE INVENTION

A more precise description of the individual components of the compositions of the invention follows:

a) Acrylate and Methacrylate

A polymerizable monomer containing one or more of the following groups:

$$-O-\overset{O}{\overset{\|}{C}}-\overset{R}{\overset{|}{C}}=CH_2$$

Wherein R = H or $CH_3$.

This includes monofunctional acrylate and methacrylate esters such as methyl methacrylate, butyl methacrylate, lauryl acrylate, dicyclopentenyloxyethyl acrylate and tetrahydrofurfuryl acrylate; multifunctional acrylate and methacrylate esters of polyol compounds such as trimethylolpropane trimethacrylate, ethylene glycol diacrylate, 1,6 hexanedioldiacrylate, pentaerythritol trimethacrylate, dipentaerythritol hexacrylate and pentaerythritol tetraacrylate; polyether (meth)acrylates such as the di, tri and tetraethylene glycol acrylates and methacrylates, tripropylene glycol diacrylate and polybutylene glycol dimethacrylate; acrylated epoxide resins; acrylated polyester resins, acrylated alkyd resins and acrylated polyurethane resins.

b) Cationically curable monomer or prepolymer

This includes particularly epoxy resins and monomers but also other cationically curable materials. The epoxide material may be a monomeric, dimeric, oligomeric or polymeric compound or mixture of compounds containing one or more epoxide groups.

Suitable epoxy monomers include, but are not limited to, 3,4-epoxycyclohexylmethyl-3,4-epoxycyclohexane carboxylate, bis-(3,4-epoxycyclohexyl) adipate and other cycloaliphatic epoxides; epoxide resins formed by the reaction of 4,4'-isopropylidenediphenol and epichlorohydrin; epoxide resins formed by the reaction of low molecular weight phenol-formaldehyde resins and epichlorohydrin; styrene oxide, allylglycidyl ether, glycidyl methacrylate and acrylate, limonene dioxide, epoxide derivatives of hydantoin, organic polymers containing pendant epoxide groups e.g. vinyl copolymers containing glycidyl acrylate as comonomer; epoxidised polyurethanes; epoxidised polyesters, and epoxidised siloxane resins.

Other cationically curable materials can be used instead of or in conjunction with the epoxide monomers. Suitable materials are generally polymerizable to higher molecular weights on contact with certain acids. The types of compounds that fall into this class include lactones, vinyl ethers, episulfides, phenol formaldehyde resinds, urea and melamine formaledehyde resins, methylol compounds, methylol ethers of polycarboxlic acid amides, alkyd resins containing urethane groups and resins containing carbonic acid esters of N-methylolamides. Also included are vinyl carbazole, diketene, and cyclic vinyl esters such as are disclosed in UK Patent Application 2,073,760 A.

c) Free radical-liberating photoinitiator

This component comprises a material which under the conditions of the photo-polymerization will yield a significant proportion of free radicals either by intramolecular cleavage or by intermolecular hydrogen abstraction in conjunction with a component of the composition other than the halonium salt. Such compounds are carbonyl group-containing compounds, particularly aromatic carbonyl group-containing compounds and include such materials as benzophenone, 2,2'-dimethoxy-2-phenylacetophenone, 1-benzoyl-cyclohexanol, 2-isopropylthioxanthone and 9,10-phenanthrenequinone. These compounds are defined in further detail in UK Patent Application 0010897 and are incorporated into the present description by reference.

d) The aromatic halonium salt is represented by the formulae:

$$[R_1-X-R_2]^{\oplus}_n \; Y^{n-}$$

or

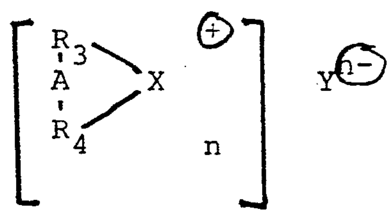

wherein X is a halogen radical selected from Cl, Br and I; $R_1$ and $R_2$, which may be the same or different, are univalent aromatic carbocyclic or aromatic heterocyclic organic radicals containing 4-20 atoms which may be substituted; $R_3$ and $R_4$, which may be the same or different, are bivalent aromatic carbocyclic or aromatic heterocyclic radicals containing 4-20 carbon atoms which may be substituted, A is a single bond or a hetero atom or a group containing a hetero atom or an alkyl or alkenyl radical containing 4-20 carbon atoms; n is 1 or 2; and Y is an anion derived from an acid which is capable of polymerizing the cationically curable component of the composition (such as an epoxide) to a higher molecular weight state.

Suitable radicals $R_1$, $R_2$, $R_3$ and $R_4$ include phenyl, thienyl, furanyl and pyrazolyl.

Suitable hetero atoms A are oxygen and sulfur and suitable hetero atom-containing groups A are S=O, C=O, O=S=O and R-N wherein R is a hydrogen atom, a lower alkyl group or a carboxylic acid acyl group or

$$R_5-\overset{|}{\underset{|}{C}}-R_6$$

in which $R_5$ and $R_6$ are the same or different and represent a hydrogen atom, an alkyl group having 1 to 4 carbon atoms or an alkenyl radical having 2 to 4 carbon atoms.

Suitable substituents in the groups $R_1$, $R_2$, $R_3$ and $R_4$ include halogen, nitro, alkyl, alkoxy, cycloalkyl, aryl, alkaryl, aralkyl, and heterocyclic groups, all of which are optionally substituted.

The anion $Y^{(n-)}$ may be for example a halogen-containing complex ion. The complex ion may be a halogenide of a metal or a metalloid element e.g. a polyhalide of boron, antimony, phosphorus, tin, bismuth, arsenic or iron. Examples of suitable anions include $BF_4^-$, $SbF_6^-$, $SbCl_6^-$, $SnCl_6^-$, $PF_6^-$, $FeCl_4^-$, $BiCl_5^=$ and $R_7SO_3^-$ wherein $R_7$ is fluorine, an optionally halogen-substituted aromatic hydrocarbon radical having 6-13 carbon atoms or an optionally halogen-substituted alkyl radical having 1-8 carbon atoms. Other suitable anions are $ClO_4^-$, $CF_3COO^-$, $ArSO_3^-$, $HSO_4^-$, $NO_3^-$ and picrate ion.

Particularly suitable halonium salts are the iodonium salts. Particularly suitable iodonium salts are those which disclosed in British Patent 1,539,192, for example 4,4'-dimethyldiphenyl iodonium hexafluorophosphate, 3,3'-dinitrodiphenyl iodonium hexafluorophosphate, 4,4-dichlorodiphenyl iodonium hexafluoroarsenate and 4,4'-dimethoxydiphenyl iodonium hexafluoroantimonate.

The invention is illustrated in further detail in the following examples, in which proportions in all cases are given by weight of the respective composition.

Example 1

The following compositions were prepared by mixing together all the listed ingredients until a homogeneous mixture was obtained:

| | Composition A | Composition B |
|---|---|---|
| SYNOCURE 3100 (Acrylate Resin by Cray Valley Products Ltd) | 69.0 | 69.0 |
| ERL-4221 (EPOXIDE MONOMER produced by Union Carbide) | 29.5 | 29.5 |
| 2,2'-DIMETHOXY-2-PHENYLACETO-PHENONE (Free Radical Photoinitiator) | 0.5 | 0.5 |
| DITOLYLIODONIUM HEXAFLUORO-PHOSPHATE (Halonium Salt) | 1.0 | - |
| GE 1014 (GROUP VIa ONIUM SALT produced by General Electric Co. | - | 1.0 |

The GE 1014 is a solution of a sulfonium (i.e. group VIa onium) salt in propylene carbonate solvent. It exhibits an absorbtion

peak in the UV region of the wavelength spectrum at 308 nm and therefore can be considered to consist at least in part of a spectrally enhanced sulfonium salt.

Thus Composition A is a composition of the invention and Composition B is an AE-type composition such as those reported on by Jung-Hsien Tsao and Ketley A D., loc. cit.

In order to compare the deep section UV curing capability of both compositions, they were separately poured and weighed into an open-topped cylindrical mould having a depth of 3 mm and a diameter of 8 mm and exposed to UV light from a medium pressure mecury arc lamp rated at 200 watts/inch (PORTA-CURE 1000) for 30 secs. The light intensity at the exposed surface was found to be 80 milliwatts per square centimeter ($mW/cm^2$) measured at 365 nm (IL-443 Photoresist Radiometer). After irradiation the entire contents of the mould were transferred to a test tube containing an excess of acetone. The tube was sealed and vigourously shaken by means of a mechanical shaker for 30 secs. The undissolved (i.e. gelled or cured) fraction was then removed, dried and weighed. The percentages of the original weights found were as follows:

| | |
|---|---|
| Composition A | 100% |
| Composition B | 94% |

indicating a faster rate of curing for the iodonium based composition.

Example 2

The compositions of Example 1 were cured in deeper cylindrical moulds, viz. 6 mm depth and 12.5 mm diameter, under the same UV conditions as given in that example, with 45 sec. exposures. Percentage gel fractions were determined in the same manner and the results obtained were as follows:

| | |
|---|---|
| Composition A | 100% |
| Composition B | 85% |

This indicates a significant superiority of the invented composition over those of Jung-Hsien Tsao and Ketley A D when cured to a greater depth.

Example 3

The following compositions were prepared:

| | Composition C | Composition D |
|---|---|---|
| SYNOCURE 3100 | 69.0 | 67.7 |
| ERL-4221 | 29.0 | 29.0 |
| 2,2-DIMETHYOXY-2-PHENYL-ACETOPHENONE | 1.0 | 1.0 |
| DITOLYLIODONIUM HEXAFLUORO-PHOSPHATE | 1.0 | - |
| GE 1014 | - | 2.3 |

As before, Composition C is of the invention and Composition D is an AE-type composition such as those reported by Jung-Hsien Tsao and Ketley A D.

Gel fractions were measured in cylindrical moulds 4 mm deep and 8 mm diameter (by the procedure outlined in Example 1) after irridiation for different exposure times. The UV conditions were similar to those used in Example 1. The results obtained were as follows:

| EXPOSURE TIME: | 30 sec | 40 sec | 60 sec |
|---|---|---|---|
| Composition C | 91 | 97 | 98 |
| Composition D | 59 | 75 | 80 |

These results indicate that the halonium based composition of the invention has an improved capability of curing through deep sections over the equivalent composition based on the group VIa onium salt of the GE 1014 catalyst.

An embodient of the present invention has unexpectedly been found to give superior bonding to polybutyleneterephthalate, a difficult to bond plastic commonly known by the trade name "Valox." It has been found that formulations of the invention which additionally employ about 10-20%, preferably 14-15%, of a carboxyl terminated acryloitrile/butadiene copolymer rubber such as Hycar 1300 x 15, sold by BF Goodrich Co. strongly bond to polybutylenephtalate. Formulations of this type may advantageously employed as potting compounds for Valox housed potentiometers or other electronic components.

Example 4

The following compositions were prepared by mixing the listed components until a homogeneous mixture was obtained:

| | Composition X | Composition Y |
|---|---|---|
| ERL-4221 | 38.0 | 43.3 |
| Tripropylene Glycol Diacrylate (TPGDA) | 58.0 | 38.5 |
| Hycar 1300 X 15 | - | 14.4 |
| Ditolyliodonium Hexafluorophosphate | 3.0 | 2.9 |
| 2,2'-Dimethoxy-2-Phenyl Acetophenone | 1.0 | 1.0 |

The compositions were coated as thin films (approx. 0.05mm thick) onto Valox substrates and cured for 30 sec. under a Technocure LC-800 medium pressure Hg lamp rated at 100W/IN. The measured light intensity was found to be 55 $mW/cm^2$ at 365 nm (U.V. Powerometer manufactured by Optical Associates Inc.). It was not possible to remove the cured films, using a sharp scalpel knife, without damaging the substrate surface.. This indicates very good adhesion to the Valox Polyster.

Composition X was modified such that the epoxide monomer ERL-4221 was replaced with TPGDA to give an "A type" composition. This formula was found to have a tacky surface and poor adhesion to Valox after irradiation under the above U.V. conditions. Composition X was further modified such that TPGDA was replaced with ERL-4221 to give an "E type" composition. This material was similarly found to have poor adhesion to Valox. These findings indicate that the good adhesion of compositions X and Y ("A E types") results from a synergism of the "A" and "E" types that could not be predicted by the performance of "A type" or "E type" alone.

Composition Y, a rubber modified version of the invention has been found useful in the potting of Valox housed potentiometers.

Examples of hybrid compositions containing a vinyl ether as the cationically curable component

Example 5

The following hybrid acrylate/vinyl ether compositions were prepared: (all weights in grams).

| | E | F | G |
|---|---|---|---|
| Acrylated epoxide resin (Synocure 3100, Cray Valley Ltd.). | 5.0 | 5.0 | 5.0 |
| Butane diol divinyl ether | 5.0 | 5.0 | 5.0 |
| 2,2-dimethoxy-2-phenylacetophenone | 0.1 | 0.1 | 0.1 |
| Ditolyliodonium hexafluorophosphate | 0.1 | - | - |
| Sulfonium salt solution (GE1014, General Electric Co.). | - | 0.23 | 0.1 |

The deep section curing capabilities of these compositions were compared by determining the % gel fractions obtained following irradiation with U.V. light. The general procedure has already been described (Page 13 line 9 above). In this example, the sample depth was 2mm and the UV lamp used was a Lumatec[TM] Light Guide source (high pressure Hg arc lamp) at an intensity of 80mW/cm². The following gel fractions were recorded:

| Exposure Time (Secs.) | Composition E | Composition F | Composition G |
|---|---|---|---|
| 30 | 57 | 47 | 39 |
| 60 | 81 | 60 | 50 |
| 90 | 95 | 63 | 58 |
| 120 | 92 | 68 | 63 |

These results indicate that the iodonium salt containing composition has improved capability of through depth curing over the equivalent composition containing the sulfonium salt, GE1014.

Furthermore, the iodonium based compositions turned a deep red/brown colour during the irradiation and resulted in opaque cured coatings. This colour change in the sulfonium based compositions was only faint and coatings with good opacity were not obtained.

Example 6

Compositions E and F from Example 5 were irradiated, in 1mm thick sections, for 60 secs. under a medium pressure mercury arc lamp (Technocure LC-800) fitted with a 2 cm water filter. The apparatus was adjusted such that the measured intensity (at 365nm) at the curing surface was 80mw/cm$^{-2}$. Gel fractions were determined and the results obtained were as follows:

| Composition E | Composition F |
|---|---|
| 96% | 76% |

further indicating the improved performance of the halonium salt containing composition over the group V1a onium equivalent.

Example 7

The following composition was prepared:

| | |
|---|---|
| Synocure 3100 | 5g |
| Butane dioldivinyl ether | 5g |
| 2,2-dimethoxy-2-phenylacetophenone | 0.1g |

and irradiated under the UV conditions described in Example for exposures of up to 30 secs. No colour formation was observed indicating the necessity of the iodonium for colour formation.

Example 8

The following compositions were prepared; (weights in grams)

| | H | I | J |
|---|---|---|---|
| Actomer X131 (Urethane acrylate resin, Hans Rahn & Co.) | 5.0 | 5.0 | 5.0 |
| Butane dioldivinyl ether | 5.0 | 5.0 | 5.0 |
| 2,2-dimethoxy-2-phenylacetophenone | 0.1 | 0.1 | 0.1 |
| Ditolyliodonium hexafluorophosphate | - | 0.1 | - |
| GE 1014 (cf Example ) | - | - | 0.23 |

and irradiated under the UV conditions outlined in Example 5 for 30 and 10 sec. exposures. For composition H, the irradiated sample showed no colour development and was completely transparent. For composition I, a dark red-brown colour formed after both exposure times. The colour formation rendered the coating opaque. For Composition J, only a slight yellow colour developed after both irradiation periods and the coating remained transparent.

These results are surprising and unexpected since both the iodonium salts and sulfonium salts are known to produce Lewis type acids on irradiation with U.V. light.

Example 9

The efficiency of a hybrid free radical/cationic curable system can be measured in terms of the time required to obtain a tack free surface on irradiation. The compositions of Example 8 were irradiated under the U.V. conditions outlined in Example 5 and after 10 secs. exposure the surface cures were judged as follows:

Composition H - Tacky Surface
Composition I - Dry Surface
Composition J - Slightly Tacky Surface

This result demonstrates an improved efficiency for the iodonium containing composition and suggests that there exists a synergism between the iodonium salt and the free radical photoinitiator.

The compositions of the present invention may, if desired, include additives such as accelerators, dyes, inhibitors, activators, fillers, pigments, anti-static agents, rubber toughening agents, flame-retardant agents, thickeners, thixotropic agents, surface active agents, viscosity modifiers, extending oils, plasticizers, tackifiers and the like. Such additives are usually blended with the prepolymers prior to or during the compounding step. Fillers include naturals and synthetic resins, carbon black, glass fibres, wood flour, clay silica, alumina, carbonates, oxides, hydroxides, silicates, glass flakes, glass beads, borates, phosphates, diatomaceous earth, talc, kaolin, barium sulfate, calcium sulfate, calcium carbonate, sand and the like. The aforesaid additives may be present in quantities up to 5 parts per part of the compositions weight.

CLAIMS

1. A curable composition comprising

a) between 1 and 99% of an acrylate or methacrylate functional monomer or prepolymer;
b) between 1 and 99% of a cationically curable monomer or prepolymer;
c) between 0.05 and 10% of a free radical-liberating photoinitiator comprising a carbonyl compound; and
d) between 0.1 and 10% of an aromatic halonium salt whose anion is a complex metal halide.

2. A composition as in Claim 1 wherein component (a) is selected from methyl methacrylate, butyl methacrylate, lauryl acrylate, dicyclopentenyloxyethyl acrylate, tetrahydrofurfuryl acrylate, trimethylolpropane trimethacrylate, ethylene glycol diacrylate, 1,6 hexanedioldiacrylate, pentaerythritol trimethacrylate, dipentaerythritol hexacrylate, pentaerythritol tetraacrylate, di, tri and tetraethylene glycol acrylates and methacrylates, tripropylene glycol diacrylate, polybutylene glycol dimethacrylate, acrylated epoxide resins, acrylated polyester resins, acrylated alkyd resins and acrylated polyurethane resins.

3. A composition as in Claim 1 wherein component (b) is an epoxy resin.

4. A composition as in Claim 3 wherein component (b) includes a member of the group consisting of 3,4-epoxycyclohexylmethyl-3,4-epoxycyclohexane carboxylate, bis-(3,4-epoxycyclohexyl) adipate and other cycloaliphatic epoxides, epoxide resins

formed by the reaction of 4,4'-isopropylidenediphenol and epichlorohydrin, epoxide resins formed by the reaction of low molecular weight phenol-formaldehyde resins and epichlorohydrin, styrene oxide, allylglycidyl ether, glycidyl methacrylate and acrylate, limonene dioxide, epoxide derivatives of hydantoin, organic polymers containing glycidyl acrylate as comonomer; epoxidised polyurethanes, epoxidised polyesters, and epoxidised siloxane resins.

A composition as in Claim 1 wherein component (b) includes a member of the group consisting of lactones, vinyl ethers, episulfides, phenol formaldehyde resins, urea and melamine formaldehyde resins, methylol compounds, methylol ethers of polycarboxylic acid amides, alkyd resins containing urethane groups, resins containing carbonic acid esters of N-methylolamides, vinyl carbazole, diketene, and cyclic vinyl esters.

A composition as in Claim 1 wherein component (c) is selected from benzophenone, 2,2'-dimethoxy-2-phenylacetophenone, 1-benzoyl-cyclohexanol, 2-isopropylthioxanthone and 9,10-phenanthrenequinone.

A composition as in Claim 1 wherein component (d) is represented by the formula

$[R_1\text{-}X\text{-}R_2]^{\oplus}_n \; Y^{n-}$ or 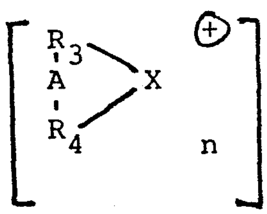 $Y^{n-}$

wherein X is a halogen radical selected from Cl, Br and I; $R_1$ and $R_2$, which may be the same or different, are univalent aromatic carbocyclic or aromatic heterocyclic organic radicals containing 4-20 carbon atoms which may be substituted;

$R_3$ and $R_4$, which may be the same or different, are bivalent aromatic carbocyclic or aromatic heterocyclic radicals containing 4-20 carbon atoms which may be substituted, A is a single bond or a hetero atom or a group containing a hetero atom or an alkyl or alkenyl radical containing 4-20 carbon atoms; n is 1 or 2; and X is an anion derived from an acid which is capable of polymerizing the cationically curable component of the composition to a higher molecular weight state.

8. A composition as in Claim 7 wherein the substituents of $R_1$, $R_2$, $R_3$ and $R_4$ are selected from phenyl, thienyl, furanyl and pyrazolyl.

9. A composition as in Claim 7 wherein A is selected from O, S, S=O, C=O, O=S=O and R-N, wherein R is a hydrogen atom, a lower alkyl group or a carboxylic acid acyl group, or

$$R_5-\overset{|}{\underset{|}{C}}-R_6$$

in which $R_5$ and $R_6$ are the same or different and represent a hydrogen atom, an alkyl group having 1 to 4 carbon atoms or an alkenyl radical having 2 to 4 carbon atoms.

10. A composition as in Claim 9 wherein $R_1$, $R_2$, $R_3$ and $R_4$ are selected from halogen, nitro, alkyl, alkoxy, cycloalkyl, aryl, alkaryl, aralkyl, and heterocyclic groups.

11. A composition as in Claim 7 wherein the anion $Y^{n-}$ is selected from $BF_4^-$; $SbF_6^-$; $SbCl_6^-$; $SnCl_6^-$; $PF_6^-$; $FeCl_4^-$; $BiCl_5^-$; $R_7SO_3^-$, wherein $R_7$ is fluorine, an optionally halogen-substituted aromatic hydrocarbon radical having 6-13 carbon atoms or an optionally halogen-substituted alkyl

radical having 1-8 carbon atoms; $ClO_4^-$; $CF_3COO^-$; $ArSO_3^-$; $HSO_4^-$; $NO_3^-$ and picrate ion.

12. A composition as in Claim 1 wherein component (d) is selected from 4,4'-dimethyldiphenyl iodonium hexafluorophosphate, 3,3'-dinitrodiphenyl iodonium hexafluorophosphate, 4,4'-dichlorodiphenyl iodonium hexafluoroarsenate and 4,4'-dimethoxydiphenyl iodonium hexafluoroantimonate.

13. A composition as in Claim 1 further comprising a carboxyl terminated acrylonitrile butadiene rubber.

14. A composition as in Claim 13 wherein said rubber is present in an amount of between about 10 and 20%.

15. A composition as in Claim 1 wherein the respective components are present in the following ranges: (a) 40-60%; (b) 37-57%; (c) 0.5-2%; and (d) 1-3%.

16. A composition as in Claim 1 wherein the respective component amounts are about: (a) 50%; (b) 47%; (c) 1%; and (d) 2%.

17. A method of curing a composition comprising

a) between 1 and 99% of an acrylate or methacrylate functional monomer or prepolymer;
b) between 1 and 99% of a cationically curable monomer or prepolymer;
c) between 0.05 and 10% of a free radical-liberating photoinitiator comprising a carbonyl compound; and
d) between 0.1 and 10% of an aromatic halonium salt whose anion is a complex metal halide,

the method comprising irradiating the composition with UV light.

18. A method as in Claim 17 wherein the composition is cured on a polybutylene terephthate substrate and said composition further comprises between 10% and 20% of a carboxyl terminated acrylonitrile/butadiene rubber.

19. A composition as in Claim 5 where component (b) is a Vinyl ether.